# EUROPÄISCHE PATENTANMELDUNG

(11) **EP 2 675 255 A2**
(43) Veröffentlichungstag der Anmeldung: **18.12.2013**
(21) Anmeldenummer: 13168752.7
(22) Anmeldetag: 22.05.2013
(51) Int. Cl.: H05K 5/06, H01F 27/14

(54) **Volumenausgleichselement**

(30) Priorität: 12.06.2012 DE 102012209830
(71) Anmelder: Witzenmann GmbH, 75175 Pforzheim (DE)
(72) Erfinder: Dr. Kämpfe, Andreas, 75173 Pforzheim (DE); Wojcik, Janus, 75179 Pforzheim (DE); Gross, Artur, 75223 Niefern-Öschelbronn (DE)
(74) Vertreter: Lemcke, Brommer & Partner

(57) **Zusammenfassung**

Die vorliegende Erfindung betrifft ein Volumenausgleichselement, enthaltend eine erste und eine zweite Membranscheibe 1, 2, die im Bereich ihrer äußeren Ränder miteinander verbunden sind und hierdurch zwischen sich ein Volumen 4 einschließen, das durch Verformen der Membranscheiben 1 , 2 veränderlich ist. Dieses umfasst weiterhin mindestens eine in einem Zentrumsbereich der ersten Membranscheibe 1 angeordnete Öffnung 9 zum Verbinden des Volumens 4 mit einem außerhalb des Volumenausgleichselements befindlichen Medium, sowie ein an dieser Öffnung 9 angeordnetes und an die erste Membranscheibe 1 angeschweißtes Anschlussteil 6 zum Herstellen einer Verbindung des Mediums mit dem Volumen 4 und zum Befestigen des Volumenausgleichselements. Des Weiteren ist das Anschlussteil zweiteilig ausgebildet, mit einem Befestigungsteil 6, das von außen an die erste Membranscheibe 1 angesetzt ist, und einem Gegenlagerteil 7, das dem Befestigungsteil 6 gegenüberliegt und von innen an die erste Membranscheibe 1 angesetzt ist, wobei das Befestigungsteil 6 und das Gegenlagerteil 7 die erste Membranscheibe 1 zwischen sich klemmen.

## Beschreibung

Die Erfindung betrifft ein Volumenausgleichselement nach dem Oberbegriff des Anspruchs 1. Ein solches Volumenausgleichselement umfasst zwei Membranscheiben, die im Bereich ihrer äußeren Ränder miteinander verbunden sind und hierdurch zwischen sich ein Volumen einschließen, das durch Verformen der Membranscheiben veränderlich ist. In einem Zentrumsbereich einer ersten Membranscheibe ist eine Öffnung angeordnet, die zum Verbinden des zwischen den Membranscheiben eingeschlossenen Volumens mit einem außerhalb des Volumenausgleichselements befindlichen Medium dient. An dieser Öffnung ist ein Anschlussteil zum Herstellen einer Verbindung des Mediums mit dem Volumen angeordnet und an der Membranscheibe angeschweißt. Das Anschlussteil dient außerdem zum Befestigen des Volumenausgleichselements an einer Vorrichtung, die mit dem Volumenausgleichselement versehen werden soll.

Volumenausgleichselemente der vorliegenden Art werden oft dann verwendet, wenn eine Flüssigkeit in einem geschlossenen Behälter ohne Gaseinschlüsse, die sich komprimieren ließen, Wärmeschwankungen ausgesetzt ist und/oder Elemente innerhalb des Behälters oder der Behälter selbst mit veränderlichen Temperaturen beaufschlagt werden, so dass die Flüssigkeit aufgrund von Wärmeausdehnungseffekten Volumenänderungen unterliegt. Da keine komprimierbaren Gaseinschlüsse vorhanden sind, müssen diese Volumenveränderungen kompensiert werden, insbesondere mit einem Volumenausgleichselement der vorliegenden Art.

Ein Hauptanwendungsbereich für ein solches Volumenausgleichselement, auf den die vorliegende Erfindung jedoch nicht eingeschränkt ist, ist der Einsatz in Transformatoren, die mit Transformatorenöl gefüllt sind. Das Tranformatorenöl ist aufgrund der im Transformator auftretenden Temperaturänderungen temperaturbedingten Volumenveränderungen ausgesetzt, die von Volumenausgleichselementen ausgeglichen werden.

Hierfür gibt es grundsätzlich zwei Möglichkeiten: Ein Volumenausgleichselement mit zwei Membranscheiben, die zwischen sich ein Volumen einschließen, kann in einer ersten Variante flüssigkeitsdicht ausgestaltet sein und in das Medium, beispielsweise also das Transformatorenöl, eingebracht werden. Wenn das Volumen des Volumenausgleichselements mit Gas gefüllt ist, kann dieses komprimiert oder expandiert werden, um die Volumenänderungen des Mediums auszugleichen, wobei das Medium jedoch nicht in Kontakt mit dieser Gasfüllung kommt.

Die vorliegende Erfindung betrifft eine zweite Variante von Volumenausgleichselementen: Diese werden außerhalb des Mediums, dessen Volumenänderungen kompensiert werden sollen, angeordnet, und es wird eine Verbindung zwischen dem Inneren des Volumenausgleichselements und dem Medium hergestellt, so dass ein sich ausdehnendes Medium in das Innere des Volumenausgleichselements fließen kann. Das Volumenausgleichselement setzt dem idealerweise eine elastische Gegenkraft entgegen, so dass das ausgelagerte Volumen des Mediums wieder zurückfließen kann, wenn sich dieses wieder abkühlt. Volumenausgleichselemente der vorliegenden Art werden daher auch als Dehnzellen bezeichnet.

Volumenausgleichselemente, deren Innenraum mit dem Medium verbunden werden und die aus zwei Membranscheiben hergestellt sind, werden im Stand der Technik oft mit einem Nippel am zylindrischen Rand der beiden Membranscheiben versehen, um das Medium mit dem Inneren des Volumenausgleichselements verbinden zu können. Soweit die Dehnung, die das Volumenausgleichselement maximal erfährt, nur vergleichsweise gering ist, werden hierdurch gute Ergebnisse erzielt. Sobald die Dehnung jedoch eine größere Auswölbung der beiden Membranscheiben verursacht, macht sich der Nippel als Schwachstelle bemerkbar und führt oft zu einer Beulung, die das maximal nutzbare Volumen des Elements begrenzt.

Es ist daher bekannt, Volumenausgleichselemente mittig anzubinden, wobei in einer der beiden Membranscheiben eine in etwa mittig angeordnete Öffnung vorhanden ist, über die das von den Membranscheiben eingeschlossene Volumen mit dem Medium verbunden werden kann. Diese Verbindung erfolgt mit einem Anschlussteil, das mit der Membranscheibe fest verbunden ist, die entsprechende Öffnung überdeckt und das Volumenausgleichselement mit einem Behältnis verbindet, in dem sich das auszugleichende Medium befindet. Gleichzeitig dient das Anschlussteil zur mechanischen Befestigung des Volumenausgleichselements an diesem Behältnis. Von diesem Stand der Technik geht die vorliegende Erfindung aus.

Bei solchen bekannten Volumenausgleichselementen treten allerdings dann Probleme auf, wenn diese Elemente Vibrationen bzw. Schwingungen ausgesetzt werden, wie sie z.B. beim Transport von Transformatoren von auftreten können. Denn die Verbindung zwischen dem notwendigerweise mechanisch stabil ausgebildeten und damit recht steifen Anschlussteil mit der dünnwandigen Membranscheibenstruktur des Volumenausgleichselements ist langfristig nicht vibrationsfest und es treten bei Schwingungsbelastungen nach einiger Zeit Ermüdungsbrüche der Membranscheiben auf, meist im Bereich der Schweißnaht.

Der vorliegenden Erfindung liegt daher die Aufgabe zugrunde, ein Volumenausgleichselement der oben genannten Art hinsichtlich seiner Vibrations- bzw. Schwingungsfestigkeit zu verbessern.

Gelöst ist diese Aufgabe durch ein Volumenausgleichselement mit den Merkmalen des Anspruchs 1. Bevorzugte Ausgestaltungen und Weiterbildungen des erfindungsgemäßen Volumenausgleichselements finden sich in den Ansprüchen 2 bis 15.

Erfindungsgemäß wird ein Volumenausgleichselement der eingangs genannten Art also dadurch modifiziert, dass das Anschlussteil zweiteilig ausgebildet wird, und zwar mit einem Befestigungsteil, das von außen an die erste Membranscheibe angesetzt ist, und einem Gegenlagerteil, das dem Befestigungsteil gegenüberliegt und von innen an die erste Membranscheibe angesetzt ist. Das Befestigungsteil und das Gegenlagerteil sind hierbei solcherart miteinander verbunden, dass sie die erste Membranscheibe zwischen sich klemmen. Durch diese Klemmung wird die Vibrationsfestigkeit der Verbindung des Anschlussteils mit der Membranscheibe deutlich verbessert; insbesondere wird die Schweißnaht mechanisch entlastet. Hierdurch wird der Bewegungseintrag insbesondere in die Schweißnaht signifikant vermindert, was die Vibrationsfestigkeit des Volumenausgleichselements vorteilhaft erhöht.

Besonders bevorzugt ist es im Rahmen der vorliegenden Erfindung, wenn das Gegenlagerteil als Haltescheibe ausgebildet ist oder einen als Haltescheibe ausgebildeten Bereich umfasst, und das Gegenlagerteil mittels dieser Haltescheibe mit der ersten Membranscheibe verschweißt ist, und zwar in einem vom äußeren Rand der Haltescheibe beabstandeten Bereich. Durch das Nach-Innen-Verlagern der Schweißnaht in einen Bereich, in dem die dünne Membranscheibe vom deutlich steiferen Gegenlagerteil unterstützt wird, wird die Schweißnaht weiter mechanisch entlastet. Da erfindungsgemäß die Membranscheibe zwischen dem Gegenlagerteil und dem Befestigungsteil geklemmt ist, wird die Schweißnaht auch nicht durch etwaige Schwingungsbewegungen der Membranscheibe belastet, denn an dieser Stelle kann auch die Membranscheibe nicht schwingen, jedenfalls nicht relativ zum Gegenlagerteil.

Um die vorteilhafte höhere Steifigkeit des Gegenlagerteils mit Haltescheibe zu gewährleisten, ist es im Rahmen der vorliegenden Erfindung bevorzugt, wenn die Haltescheibe zumindest ein einem Bereich der Verschweißung eine Dicke aufweist, die mindestens dem Dreifachen der Dicke der Membranscheibe entspricht.

Um die Vibrationsfestigkeit des erfindungsgemäßen Volumenausgleichselements weiter zu erhöhen, kann vorgesehen sein, dass die Dicke der Haltescheibe zu ihrem äußeren Rand hin abnimmt, so dass sie dort weicher wird und eine gewisse Beweglichkeit der Membranscheibe zulässt. Alternativ oder zusätzlich kann vorgesehen sein, dass die Haltescheibe und/oder das Befestigungsteil an derjenigen Seite ihres äußeren Randes, die zur zugeordneten Membranscheibe weist, abgerundet ist. Eine etwaige Schwingungsbewegung der Membranscheibe kann hierdurch an den äußeren Rändern der Haltescheibe und/oder des Befestigungsteils sanft aufgefangen werden, indem die Membranscheibe an den entsprechenden Rändern nicht an einer unnachgiebigen Kante umgelenkt wird.

Im Rahmen der vorliegenden Erfindung ist es besonders bevorzugt, wenn das Gegenlagerteil gleichzeitig mit der zugeordneten Membranscheibe, und mit dem Befestigungsteil verschweißt ist. Dies erhöht die Stabilität der Struktur, verbindet das Gegenlagerteil mit dem Befestigungsteil und kann, soweit das Gegenlagerteil als Haltescheibe ausgebildet oder mit einer solchen versehen ist, durch unkompliziertes Durchschweißen durch die Haltescheibe, die Membranscheibe und das Befestigungsteil umgesetzt werden.

Das Befestigungsteil ist zweckmäßigerweise mit einem Durchgangskanal zum Herstellen der gewünschten Verbindung des Mediums mit dem zwischen den Membranscheiben gebildeten Volumen versehen und das Gegenlagerteil weist ebenso zweckmäßig eine Durchgangsöffnung auf, um das zwischen den Membranscheiben eingeschlossene Volumen über die Öffnung in der ersten Membranscheibe mit dem Durchgangskanal zu verbinden.

Im Rahmen der vorliegenden Erfindung kann außerdem vorgesehen sein, dass auch der Zentrumsbereich der zweiten Membranscheibe, die dem Anschlussteil gegenüberliegt, eine Öffnung aufweist. Mittels dieser Öffnung kann eine Verbindung des Inneren des Volumenausgleichselements mit einer Umgebung hergestellt werden; insbesondere kann eine Evakuierungsvorrichtung an diese zweite Öffnung angesetzt werden, um das zwischen den beiden Membranscheiben gebildete Volumen zu evakuieren, so dass ein maximal nutzbares Volumen zum Volumenausgleichen vorhanden ist.

Um insbesondere zu verhindern, dass beim Evakuieren des Volumenausgleichselements die beiden Membranscheiben sich aneinander anlegen, bietet es weitere Vorteile, wenn das Befestigungsteil und/oder das Gegenlagerteil Distanzelemente aufweisen, die sich in das durch die beiden Membranscheiben gebildete Volumen hinein erstrecken und so verhindern, dass die beiden Membranscheiben sich näherkommen, als dies durch die Distanzelemente vorgegeben ist. Dies ist nicht nur bei einem Vorab-Evakuieren des Volumenausgleichselements vorteilhaft, sondern auch dann, wenn sich das Medium über ein bestimmtes Maß hinaus zusammenzieht, so dass das Volumenausgleichselement vom Umgebungsdruck zusammengepresst wird.

Wie an sich bekannt, sind die Membranscheiben im Rahmen der vorliegenden Erfindung vorzugsweise im Wesentlichen kreisförmig ausgebildet und profiliert, vorzugsweise mit einem konzentrischen Wellenprofil. Weiter bevorzugt bestehen die Membranscheiben aus Metall, insbesondere aus Edelstahl.

Soweit das Befestigungsteil mit einem Durchgangskanal und das Gegenlagerteil mit einer Durchgangsöffnung versehen sind, ist es im Rahmen der vorliegenden Erfindung besonders bevorzugt, im Zentrumsbereich der zweiten Membranscheibe eine Öffnung vorzusehen, an der ein Verbindungsteil von außen an die zweite Membranscheibe angesetzt wird und an der ein Verbindungs-Gegenlagerteil, das dem Verbindungsteil gegenüberliegt, von innen an die zweite Membranscheibe angesetzt wird. Dieses Verbindungsteil wird also ebenso an der zweiten Membranscheibe angebracht, wie das erfindungsgemäße Anschlussteil an der ersten Membranscheibe angebracht ist. Das Verbindungsteil dient dann gleichzeitig als Anschlussteil für ein zweites Volumenausgleichselement derselben Art, also mit einer ersten und einer zweiten Membranscheibe, einem von diesem eingeschlossenen Volumen und einem Gegenlagerteil, das dem Verbindungsteil gegenüberliegt und von innen an die erste Membranscheibe angesetzt ist, wobei das Gegenlagerteil und das Verbindungsteil die erste Membranscheibe des zweiten Volumenausgleichselements zwischen sich klemmen.

Aufgrund der Stabilität der erfindungsgemäßen Anschlusstechnik für ein Volumenausgleichselement ist es möglich, einen Stapel von zwei oder mehr übereinander angeordneten Volumenausgleichselementen über ein einziges Anschlussteil an ein Behältnis und dergleichen anzuschließen, und zwar vorzugsweise so, dass auch die Verbindungsteile zwischen den einzelnen Volumenausgleichselementen in erfindungsgemäßer Weise, entsprechend dem Anschlussteil, an den jeweiligen zentralen Öffnungen der weiteren Volumenausgleichselemente angebracht sind. Ein Volumenausgleichselement-Stapel umfasst naturgemäß ein Vielfaches des Volumens eines einzigen Volumenausgleichselements, ohne die Dimensionen des einzelnen Volumenausgleichselements verändern zu müssen. Letzteres hat wiederum vorteilhafte Auswirkungen auf die Stabilität und die Lebensdauer der Volumenausgleichselemente.

Vorzugsweise wird das Verbindungsteil mit einem Durchgangskanal und das Verbindungs-Gegenlagerteil mit einer Durchgangsöffnung versehen, die im Wesentlichen mit dem Durchgangskanal des Befestigungsteils und mit der Durchgangsöffnung des Gegenlagerteils fluchten. Dies ermöglicht, ein innerhalb der Durchgangsöffnungen und der Durchgangskanäle verlaufendes, gleitend gelagertes oder teleskopartig längenveränderliches Führungselement in den Volumenausgleichselementen-Stapel einzuziehen. Mit einem solchen Führungselement wird verhindert, dass die einzelnen Volumenausgleichselemente im Stapel relativ zueinander eine Kippbewegung ausführen. Des Weiteren wird insgesamt die Stabilität des Stapels verbessert. Das Führungselement kann hierbei auch mit Anschlägen oder Auszugsbegrenzungen versehen sein, die verhindern, dass sich die Volumenausgleichselemente des Stapels über ein bestimmtes Maximalvolumen hinaus ausdehnen können.

Ein solches bevorzugt vorhandenes Führungselement in den Durchgangskanälen und Durchgangsöffnungen des Verbindungsteils und des Befestigungsteils ist besonders bevorzugt ein Teleskoprohr, das mit Umfangsöffnungen zur Verbindung eines Innenraums des Teleskoprohrs mit dem Volumen des Volumenausgleichselements versehen ist. Es sind jedoch auch andere Arten von Führungselementen, beispielsweise ein Gleitstift, eine Mehrzahl von Führungsstangen und dergleichen denkbar.

Alternativ zum internen Führungselement ist es schließlich auch möglich, die Volumenausgleichselemente eines über Verbindungsteile gebildeten Stapels mittels eines außen umgebenden Korbes zu stabilisieren.

Ein Ausführungsbeispiel für ein erfindungsgemäß ausgestaltetes Volumenausgleichselement wird im Folgenden anhand der beigefügten Zeichnungen beschrieben und erläutert. Es zeigen:
- Figur 1: eine schematische seitliche Schnittdarstellung eines Volumenausgleichselements;
- Figur 2: das Detail X aus Figur 1;
- Figur 3: eine schematische seitliche Schnittdarstellung eines Volumenausgleichselement-Stapels.

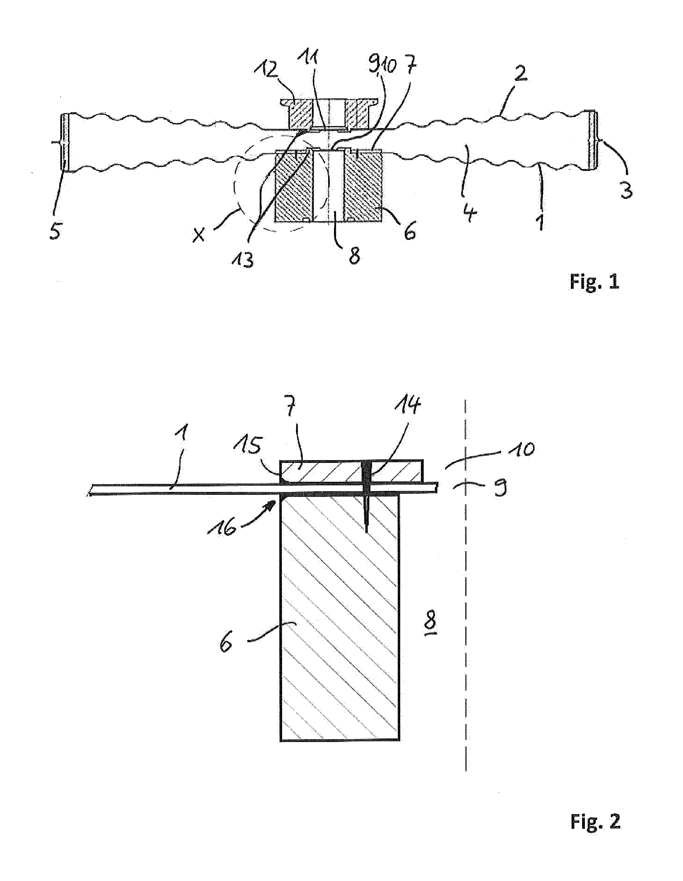

In Figur 1 ist in einer schematischen seitlichen Schnittdarstellung ein Beispiel für ein erfindungsgemäß ausgestaltetes Volumenausgleichselement dargestellt. Dieses umfasst eine erste Membranscheibe 1 und eine zweite Membranscheibe 2, die in Draufsicht kreisrund ausgebildet, aus einem dünnen Edelstahlblech gefertigt und mit konzentrischen Wellungen versehen sind. Mittels einer randseitig umlaufenden Schweißnaht 3 sind die beiden Membranscheiben 1, 2 zusammengefügt, wodurch sie ein Volumen 4 zwischen sich einschließen. Im Bereich der Schweißnaht 3 befindet sich, ebenfalls randseitig umlaufend, ein Stabilisierungsring 5, der sicherstellt, dass zwischen den Membranscheiben 1, 2 ein Mindestvolumen bestehen bleibt, auch wenn der Innenraum 4 evakuiert wird.

Weiterhin umfasst das dargestellte Volumenausgleichselement ein in einem Zentrumsbereich der ersten Membranscheibe 1 angebrachtes Anschlussteil, das aus einem Befestigungsteil 6 und einem Gegenlagerteil 7 besteht. Das von außen an die erste Membranscheibe 1 angesetzte Befestigungsteil 6 ist ein sehr steif ausgebildetes Bauteil mit einem Durchgangskanal 8, der an einer Öffnung 9 in der ersten Membranscheibe 1 mündet. Das von innen an die erste Membranscheibe 1 angesetzte Gegenlagerteil 7 weist an derselben Öffnung 9 ebenfalls eine Durchgangsöffnung 10 auf, so dass der Durchgangskanal 8 im Ergebnis mit dem Volumen 4 in Verbindung steht.

Dem aus Befestigungsteil 6 und Gegenlagerteil 7 bestehenden Anschlussteil gegenüberliegend, ist an der zweiten Membranscheibe 2 ebenfalls eine Öffnung 11 vorgesehen, auf der ein Absaugnippel 12 zum Evakuieren des von den beiden Membranscheiben 1, 2 eingeschlossenen Volumens 4 befestigt ist. Sowohl am Absaugnippel 12 als auch am Gegenlagerteil 7 sowie am Befestigungsteil 6 sind Distanzelemente 13 vorhanden, die in das Innere des Volumens 4 hineinragen und verhindern, dass die beiden Membranscheiben 1, 2 beim Evakuieren des Volumens 4 aneinandergelegt werden. Aufgrund der Distanzelemente 13 bleibt auch im mittigen Bereich, an dem das Anschlussteil 6, 7 angebracht ist, ein Mindestvolumen bestehen. Randseitig verhindert der Stabilisierungsring 5 ein Aufeinanderlegen der beiden Membranscheiben 1, 2.

Wie Figur 1 verdeutlicht, kann das dargestellte Volumenausgleichselement mittels des Befestigungsteils 6 an einem (nicht dargestellten) Behältnis mit einem Medium befestigt werden, wobei es sich beispielsweise um Isolieröl eines Hochspannungswandlers handelt. Gleichzeitig kann dieses Medium durch den Durchgangskanal 8 des Befestigungsteils 6, die Öffnung 9 in der Membranscheibe 1 und die Durchgangsöffnung 10 im Gegenlagerteil 7 in das Volumen 4 des Volumenausgleichselements hineinströmen. Durch Aufwölben der Membranscheiben 1 und 2, wodurch sich diese auseinanderbewegen und die gesamte Struktur ein linsenförmiges Aussehen erhält, kann das Volumenausgleichselement die benötigte Menge des Mediums in sich aufnehmen, die durch Volumenänderung des Mediums im entsprechenden Behältnis dem Behältnis entnommen werden muss. Dieser Vorgang ist reversibel.

Anhand Figur 2, einer Detailvergrößerung des Details X aus Figur 1 ist erkennbar, dass das Gegenlagerteil 7 im vorliegenden Ausführungsbeispiel als Haltescheibe ausgebildet ist, die in etwa die dreifache Dicke der Membranscheibe 1 aufweist. Das Gegenlagerteil 7 ist durch die Öffnung 9 in der Membranscheibe 1 hindurch mit dem Befestigungsteil 6 verbunden und klemmt die Membranscheibe 1 zwischen sich und dem Befestigungsteil 6. Zusätzlich sind das Gegenlagerteil 7 und das Befestigungsteil 6 mit einer Schweißnaht 14 aneinander festgelegt, wobei durch die Membranscheibe 1 hindurchgeschweißt wurde, so dass auch diese mit dem Befestigungsteil 6 verschweißt ist.

Die Schweißnaht 14 ist von einem äußeren Rand 15 des Gegenlagerteils 7 bzw. der Haltescheibe beabstandet, so dass zwischen der Schweißnaht 14 und dem äußeren Rand 15 eine gewisse Strecke verbleibt, in der die Membranscheibe 1 zwischen dem Befestigungsteil 6 und dem Gegenlagerteil 7 geklemmt ist und sich auch bei einer Schwingungsanregung nicht bewegen kann. Schwingungsbewegungen der Membranscheibe 1 werden also nicht bis zur Schweißnaht 14 weitergeleitet, so dass diese weitgehend frei von Schwingungsbelastungen bleibt.

Der äußere Rand 15 des Gegenlagerteils 7 sowie ein äußerer Rand 16 des Befestigungsteils 6 sind an ihrer zur Membranscheibe 1 weisenden Seite jeweils abgerundet, so dass Schwingungsbewegungen der Membranscheibe 1 nicht zu möglicherweise nachteiligen Auslenkungen um eine Kante führen.

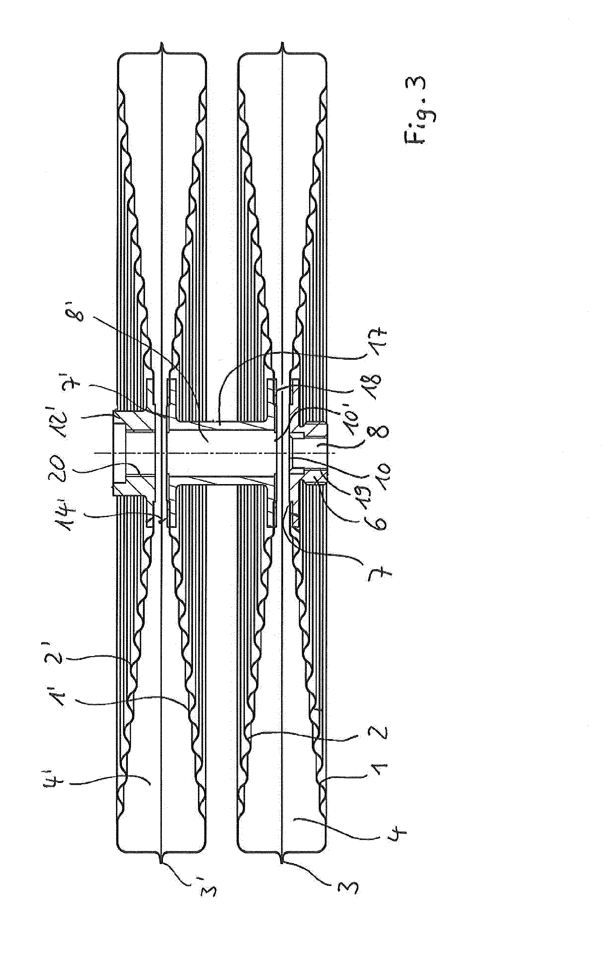

Figur 3 ist schließlich eine schematische seitliche Schnittdarstellung, entsprechend der Darstellung aus Figur 1, die ein Beispiel für einen Stapel aus zwei erfindungsgemäß ausgestalteten Volumenausgleichselementen zeigt. Beide Volumenausgleichselemente umfassen wiederum eine erste Membranscheibe 1, 1' und eine zweite Membranscheibe 2, 2', die in Draufsicht kreisrund ausgebildet, aus einem dünnen Edelstahlblech gefertigt und mit konzentrischen Wellungen versehen sind. Auch hier sind die beiden Membranscheiben 1, 1', 2, 2' jeweils mit randseitig umlaufenden Schweißnähten 3, 3' zusammengefügt, wodurch sie jeweils ein Volumen 4, 4' zwischen sich einschließen.

Wie bereits in Figur 1 dargestellt, ist auch beim Ausführungsbeispiel der Figur 3 ein Anschlussteil vorgesehen, das erfindungsgemäß aus einem Befestigungsteil 6 und einem Gegenlagerteil 7 besteht. Das Befestigungsteil 6 ist von außen an die erste Membranscheibe 1 angesetzt und enthält einen Durchgangskanal 8, der an einer Öffnung 9 in der ersten Membranscheibe 1 mündet. Das von innen an die erste Membranscheibe 1 angesetzte Gegenlagerteil 7 weist eine Durchgangsöffnung 10 auf, so dass der Durchgangskanal 8 mit dem Volumen 4 in Verbindung steht.

Gegenüberliegend ist an der zweiten Membranscheibe 2 ein Verbindungsteil 17 angebracht, wobei dieses, wie das Befestigungsteil 6, von außen an die zweite Membranscheibe 2 angesetzt ist und mit einem von innen an die zweite Membranscheibe 2 angesetzten Verbindungs-Gegenlagerteil 18 zusammenwirkt, indem das Verbindungsteil 17 und das Verbindungs-Gegenlagerteil 18 die zweite Membranscheibe 2 zwischen sich klemmen.

Wie in dem in den Figuren 1 und 2 dargestellten Ausführungsbeispiel, sind das Gegenlagerteil 7 und das Befestigungsteil 6 auch in Figur 3 durch die Öffnung 9 in der Membranscheibe 1 hindurch untereinander verbunden und zusätzlich mit einer Schweißnaht aneinander festgelegt. Hierbei wurde durch die Membranscheibe 1 hindurchgeschweißt, so dass auch diese mit dem Befestigungsteil 6 verschweißt ist.

In entsprechender Weise sind auch das Verbindungsteil 17 und das Verbindungs-Gegenlagerteil 18 durch die Öffnung in der zweiten Membranscheibe 2 hindurch miteinander verbunden, und auch hier ist zusätzlich eine Schweißnaht zwischen dem Verbindungs-Gegenlagerteil 18, der zweiten Membranscheibe 2 und dem Verbindungsteil 17 vorgesehen, so dass die Befestigung des Verbindungsteils 17 an der zweiten Membranschreibe 2 in entsprechender Weise gebildet wurde, wie die Befestigung des Befestigungsteils 6 an der ersten Membranscheibe 1.

Das Verbindungsteil 17 weist ebenfalls einen Durchgangskanal 8' auf, der mit dem Durchgangskanal 8 im Befestigungsteil 6 fluchtet und das Volumen 4 des ersten Volumenausgleichselements mit dem Volumen 4' des zweiten Volumenausgleichselements verbindet. Denn das Verbindungsteil 17 verhält sich hinsichtlich des zweiten Volumenausgleichselements wie das Befestigungsteil 6 hinsichtlich des ersten Volumenausgleichselements, und die Befestigung des Verbindungsteils 17 an der ersten Membranscheibe 1' des zweiten Volumenausgleichselements erfolgt ebenso wie die Befestigung des Befestigungsteils 6 an der ersten Membranscheibe 1 des ersten Volumenausgleichselements, also mit einem Gegenlagerteil 7', das von innen an die erste Membranscheibe 1' angesetzt ist und diese zwischen sich und dem Verbindungsteil 17 klemmt. Zusätzlich ist eine Schweißnaht 14' vorgesehen, die das Gegenlagerteil 7', das Verbindungsteil 17 und die erste Membranscheibe 1' untereinander festlegt.

Das in Figur 3 dargestellte Ausführungsbeispiel eines Stapels aus Volumenausgleichselementen besteht lediglich aus zwei Volumenausgleichselementen, und das zweite Volumenausgleichselement ist an seiner zweiten Membranscheibe 2' mit einem Absaugnippel 12' zum Evakuieren der Volumina 4 und 4' versehen. Anstelle des Absaugnippels 12' kann hier ein zweites Verbindungsteil angebracht werden, an dem dann ein drittes Volumenausgleichselement und so weiter angebracht werden kann.

Innerhalb der in Figur 3 dargestellten Durchgangskanäle 8, 8' und Durchgangsöffnungen 10, 10' ist vorgesehen, ein (nicht dargestelltes) Teleskoprohr als Führungselement einzusetzen. Hierzu wird der Teil des Teleskoprohrs mit kleinerem Durchmesser in ein Innengewinde 19 im Befestigungsteil 6 eingeschraubt, während der Teil des Teleskoprohrs mit größerem Durchmesser in ein Innengewinde 20 des Absaugnippels 12' eingeschraubt wird. Das Teleskoprohr ist dann also einerseits am Befestigungsteil 6 und andererseits am Absaugnippel 12' befestigt, wobei seine Länge zwischen diesen beiden Befestigungspunkten variabel ist. Allerdings stellt es sicher, dass das Befestigungsteil 6 und der Absaugnippel 12' und somit auch das Verbindungsteil 17 zwangsgeführt miteinander fluchten, auch wenn sich diese Teile axial auseinanderbewegen, wenn die Volumina 4, 4' der beiden Volumenausgleichselemente gefüllt werden, und umgekehrt.

Zumindest in denjenigen Bereichen, in denen das Teleskoprohr die beiden Volumina 4, 4' durchgreift, weist das Teleskoprohr Umfangsöffnungen auf, um seinen Innenraum mit den Volumina 4, 4' der Volumenausgleichselemente zu verbinden.

Wenn das Teleskoprohr oder ein sonstiges Führungselement mit einem Endanschlag für eine maximale axiale Längung versehen ist, fungiert dieses Führungselement dann außerdem als Sicherung gegen eine zu große Ausdehnung der Volumenausgleichselemente. Umgekehrt kann ein internes Führungselement auch den Weg begrenzen, den das Befestigungsteil 6 und der Absaugnippel 12' zueinander hin zurücklegen können, so dass ohne zusätzliche Maßnahmen verhindert werden kann, dass sich die beiden Membranscheiben 1, 2 bzw. 1', 2' aufeinanderlegen, wenn Medium aus den Volumina 4, 4' entnommen wird.

## Patentansprüche

1. Volumenausgleichselement, enthaltend eine erste (1) und eine zweite (2) Membranscheibe, die im Bereich ihrer äußeren Ränder miteinander verbunden sind und hierdurch zwischen sich ein Volumen (4) einschließen, das durch Verformen der Membranscheiben (1, 2) veränderlich ist, mit mindestens einer in einem Zentrumsbereich der ersten Membranscheibe (1) angeordneten Öffnung (9) zum Verbinden des Volumens (4) mit einem außerhalb des Volumenausgleichselements befindlichen Medium, sowie mit einem an dieser Öffnung (9) angeordneten und an die erste Membranscheibe (1) angeschweißten Anschlussteil (6, 7) zum Herstellen einer Verbindung des Mediums mit dem Volumen (4) und zum Befestigen des Volumenausgleichselements,
**dadurch gekennzeichnet,**
**dass** das Anschlussteil zweiteilig ausgebildet ist, mit einem Befestigungsteil (6), das von außen an die erste Membranscheibe (1) angesetzt ist, und einem Gegenlagerteil (7), das dem Befestigungsteil (6) gegenüberliegt und von innen an die erste Membranscheibe (1) angesetzt ist, wobei das Befestigungsteil (6) und das Gegenlagerteil (7) die erste Membranscheibe (1) zwischen sich klemmen.

2. Volumenausgleichselement nach Anspruch 1,
**dadurch gekennzeichnet,**
**dass** das Gegenlagerteil (7) als Haltescheibe ausgebildet ist oder einen als Haltescheibe ausgebildeten Bereich umfasst, und dass das Gegenlagerteil (7) mittels der Haltescheibe, in einem vom äußeren Rand (15) der Haltescheibe beabstandeten Bereich derselben, mit der ersten Membranscheibe (1) verschweißt ist.

3. Volumenausgleichselement nach Anspruch 2,
**dadurch gekennzeichnet,**
**dass** die Haltescheibe (7) zumindest im Bereich der Verschweißung (14) eine Dicke aufweist, die mindestens dem Dreifachen der Dicke der ersten Membranscheibe (1) entspricht.

4. Volumenausgleichselement nach einem der Ansprüche 2 oder 3,
**dadurch gekennzeichnet,**
**dass** die Haltescheibe (7) und/oder das Befestigungsteil (6) an derjenigen Seite ihres äußeren Randes (15, 16), die zur ersten Membranscheibe (1) weist, abgerundet sind.

5. Volumenausgleichselement nach mindestens einem der Ansprüche 2 bis 4, **dadurch gekennzeichnet,**
**dass** die Dicke der Haltescheibe (7) zu ihrem äußeren Rand (15) hin abnimmt.

6. Volumenausgleichselement nach mindestens einem der Ansprüche 1 bis 5, **dadurch gekennzeichnet,**
**dass** das Gegenlagerteil (7) gleichzeitig mit der ersten Membranscheibe (1) und mit dem Befestigungsteil (6) verschweißt ist.

7. Volumenausgleichselement nach mindestens einem der Ansprüche 1 bis 6, **dadurch gekennzeichnet,**
**dass** die Membranscheiben (1, 2) im Wesentlichen kreisförmig ausgebildet sind.

8. Volumenausgleichselement nach mindestens einem der Ansprüche 1 bis 7, **dadurch gekennzeichnet,**
**dass** die Membranscheiben (1, 2) profiliert sind, vorzugsweise mit einem konzentrischen Wellenprofil.

9. Volumenausgleichselement nach mindestens einem der Ansprüche 1 bis 8, **dadurch gekennzeichnet,**
**dass** das Befestigungsteil (6) und/oder das Gegenlagerteil (7) Distanzelemente (13) aufweisen, die sich in das durch die beiden Membranscheiben (1, 2) gebildete Volumen (4) hinein erstrecken.

10. Volumenausgleichselement nach mindestens einem der Ansprüche 1 bis 9 **dadurch gekennzeichnet,**
**dass** auch der Zentrumsbereich der zweiten Membranscheibe (2) eine Öffnung (11) aufweist, mit der eine Verbindung des durch die beiden Membranscheiben (1, 2) gebildeten Volumens (4) mit einer Umgebung des Volumenausgleichselements herstellbar ist.

11. Volumenausgleichselement nach mindestens einem der Ansprüche 1 bis 10, **dadurch gekennzeichnet,**
**dass** das Befestigungsteil (6) einen Durchgangskanal (8) zum Herstellen einer Verbindung des Mediums mit dem Volumen (4) aufweist und dass das Gegenlagerteil (7) mit einer Durchgangsöffnung (10) versehen ist, um das zwischen den Membranscheiben (1 , 2) eingeschlossene Volumen (4) mit dem Durchgangskanal (8) zu verbinden.

12. Volumenausgleichselement nach Anspruch 11,
**dadurch gekennzeichnet,**
**dass** auch der Zentrumsbereich der zweiten Membranscheibe (2) eine Öffnung (11) aufweist, und dass ein Verbindungsteil (17), das außen an die zweite Membranscheibe (2) angesetzt ist, und ein Verbindungs-Gegenlagerteil (18), das dem Verbindungsteil (17) gegenüberliegt und von innen an die zweite Membranscheibe (2) angesetzt ist, an der Öffnung (11) vorgesehen ist, wobei das Verbindungsteil (17) gleichzeitig als Anschlussteil für ein zweites Volumenausgleichselement mit einer ersten (1') und einer zweiten (2') Membranscheibe und einem von diesen eingeschlossenen Volumen (4') ausgebildet ist.

13. Volumenausgleichselement nach Anspruch 12,
**dadurch gekennzeichnet,**
**dass** das Verbindungsteil (17) mit einem Durchgangskanal (8') und das Verbindungs-Gegenlagerteil (18) mit einer Durchgangsöffnung (10') versehen sind, die im Wesentlichen mit dem Durchgangskanal (8) des Befestigungsteils (6) und mit der Durchgangsöffnung (10) des Gegenlagerteils (7) fluchten, wobei mindestens ein innerhalb der Durchgangsöffnungen (10, 10') und der Durchgangskanäle (8, 8') verlaufendes, gleitend gelagertes oder teleskopartig längenveränderliches Führungselement vorgesehen ist.

14. Volumenausgleichselement nach Anspruch 13,
**dadurch gekennzeichnet,**
**dass** das Führungselement ein Teleskoprohr ist, das mit Umfangsöffnungen zur Verbindung eines Innenraums des Teleskoprohrs mit dem Volumen (4, 4') des Volumenausgleichselements versehen ist.

15. Stapel aus zwei oder mehr mittels Verbindungsteilen untereinander verbundenen Volumenausgleichselementen nach mindestens einem der Ansprüche 1-14.
